# EUROPÄISCHE PATENTSCHRIFT

(11) **EP 0 589 221 B1**
(45) Veröffentlichungstag und Bekanntmachung des Hinweises auf die Patenterteilung: **04.02.1998**
(21) Anmeldenummer: 93113492.8
(22) Anmeldetag: 24.08.1993
(51) Int. Cl.: H03K 19/00, H03K 19/094, H03M 5/18

(54) **Integrierte Halbleiterschaltungsanordnung**
Semiconductor integrated circuit device
Dispositif à circuit intégré semi-conducteur

(30) Priorität: 24.09.1992 DE 4232049
(43) Veröffentlichungstag der Anmeldung: 30.03.1994
(73) Patentinhaber: SIEMENS AKTIENGESELLSCHAFT, 80333 München (DE)
(72) Erfinder: Bowles, Gary, D-81541 München (DE)

(56) Entgegenhaltungen:
- PATENT ABSTRACTS OF JAPAN, Bd. 005, Nr. 019 (E-044) 4. Februar 1981& JP-A-55 147 039
- PATENT ABSTRACTS OF JAPAN, Bd. 009, Nr. 277 (E-355) 6. November 1985 & JP-A-60 121 821
- PATENT ABSTRACTS OF JAPAN, Bd. 012, Nr. 234 (E-629) 5. Juli 1988 & JP-A-63 026 115
- PATENT ABSTRACTS OF JAPAN, Bd. 003, Nr. 103 (E-134) 31. August 1979 & JP-A-54 081 736
- PATENT ABSTRACTS OF JAPAN, Bd. 006, Nr. 194 (E-134) 2. Oktober 1982 & JP-A-57 106 233
- PATENT ABSTRACTS OF JAPAN, Bd. 008, Nr. 66 (E-234)(1503) 28. Maerz 1984 & JP-A-58 215 135

## Beschreibung

Zum Testen integrierter Halbleiterschaltungen - wie beispielsweise Halbleiterspeicher - müssen Eingangsanschlüsse vorgesehen werden, die dann beim Normalbetrieb nicht mehr gebraucht werden und Platz wegnehmen. Es ist daher üblich, zwei interne Anschlüsse über eine Wandlerschaltung auf nur einem externen Anschluß zu reduzieren, wobei durch diese Wandlerschaltung dann beispielsweise ein ternäres Eingangssignal am externen Anschluß auf zwei binäre Signale an den beiden internen Anschlüssen transformiert wird. Allerdings waren bisher Eingangssignale nötig, deren Pegel höher war als die Betriebsspannung der Schaltung.

Das Dokument "PATENT ABSTRACTS OF JAPAN, Vol. 006, No. 194, beschreibt eine Schaltungsanordnung nach dem Oberbegriff des Anspruchs 1 oder 2.

Das der Erfindung zugrunde liegende Problem ist es daher, eine Schaltung zum Wandeln eines ternären Eingangssignals in zwei binäre Ausgangssignale anzugeben, die ein Eingangssignal verarbeiten kann, dessen maximaler Pegel gleich der Betriebsspannung ist.

Das Problem wird gelöst durch eine integrierte Halbleiterschaltungsanordnung nach Anspruch 1 oder 2.

Das ternäre Eingangssignal der erfindungsgemäßen Halbleiterschaltungsanordnung kann dabei drei verschiedene Werte annehmen, nämlich den Wert des Bezugspotentials, des Betriebsspannungspotentials oder einen Wert zwischen diesen beiden, wobei durch einen der drei Werte der Ruhebetriebszustand der Halbleiterschaltungsanordnung bestimmt ist. Die beiden anderen Werte werden mittels der Logikschaltung in zwei jeweil benötigte binäre Werte gewandelt und bestimmen die beiden aktiven Betriebszustände.

Wenn die gesamte integrierte Halbleiterschaltunsanordnung in MOS-Technologie realisiert ist, sind der erste und der zweite Schwellwertentscheider in vorteilhafter Weise mit jeweils einem CMOS-Inverter gebildet. Die Schaltschwelle läßt sich durch geeignete Dimensionierung der die CMOS-Inverter bildenden n-Kanal- und p-Kanal-MOS-Transistoren einstellen.

Da Widerstände in integrierten Halbleiterschaltungen verhältnismäßig schwierig zu realisieren sind, ist der erste Widerstand durch einen ersten p-Kanal-MOS-Transistor gebildet, dessen Gate-Anschluß mit dem Bezugspotential verbunden ist. Der zweite Widerstand ist durch einen als Diode betriebenen ersten n-Kanal-MOS-Transistor und der dritte Widerstand durch einen als Diode betriebenen zweiten p-Kanal-MOS-Transistor gebildet. Der vierte Widerstand ist durch einen zweiten n-Kanal-MOS-Transistor, dessen Gate-Anschluß auf Betriebsspannungspotential liegt, gebildet.

Dies hat den Vorteil, daß der Ruhebetriebszustand durch ein Nicht-Beschalten des Eingangsanschlusses eingestellt werden kann, allerdings hat sie auch den Nachteil, daß im Ruhebetriebszustand ein Ruhestrom durch die vier in Serie geschalteten Widerstände fließt und somit eine Verlustleistung auftritt. Um das Auftreten dieser Verlustleistung zu vermeiden, ist entweder der Gate-Anschluß des den ersten p-Kanal-MOS-Transistors mit dem Ausgang des ersten Schwellwertentscheider bildenden CMOS-Inverters oder der Gate-Anschluß des zweiten n-Kanal-MOS-Transistors mit dem Ausgang des den zweiten Schwellwertentscheider bildenden CMOS-Inverters verbunden. Dabei muß dann allerdings im Ruhebetriebszustand der Eingangsanschluß entweder auf Bezugspotential oder auf Betriebsspannungspotential gelegt werden.

Um das Durchschalten der CMOS-Inverter zu beschleunigen, sind in weiterer vorteilhafter Ausgestaltung der erfindungsgemäßen integrierten Halbleiterschaltungsanordnung parallel zum zweiten Widerstand ein dritten n-Kanal-MOS-Transistor dessen Gate-Anschluß mit dem Ausgang des ersten Schwellwertentscheiders verbunden ist, angeordnet und parallel zum dritten Widerstand ein dritter p-Kanal-MOS-Transistor, dessen Gate-Anschluß mit dem Ausgang des zweiten Schwellwertentscheiders verbunden ist, angeordnet.

Da durch diese Weiterbildung der Halbleiterschaltungsanordnung möglicherweise ein Verriegelungseffekt der dritten n-Kanal- und p-Kanal-MOS-Transistoren in Verbindung mit dem ersten und dem zweiten CMOS-Inverter auftreten kann, ist es zweckmäßig, zwischen den Ausgang des ersten CMOS-Inverters und dem Bezugspotential einen vierten n-Kanal-MOS-Transistor, dessen Gate-Anschluß mit dem zweiten Verbindungsknoten und zwischen dem Betriebsspannungspotential und dem Ausgang des zweiten Schwellwertentscheiders einen vierten p-Kanal-MOS-Transistor, dessen Gate-Anschluß mit dem zweiten Verbindungsknoten verbunden ist, anzuordnen.

Die Erfindung wird nachfolgend anhand von Ausführungsbeispielen mit Hilfe von Figur näher erläutert. Es zeigen dabei:
- Figur 1: ein Prinzipschaltbild,
- Figur 2: eine erste Ausführungsform und
- Figur 3: eine zweite Ausführungsform der erfindungsgemäßen integrierten Halbleiterschaltungsanordnung.

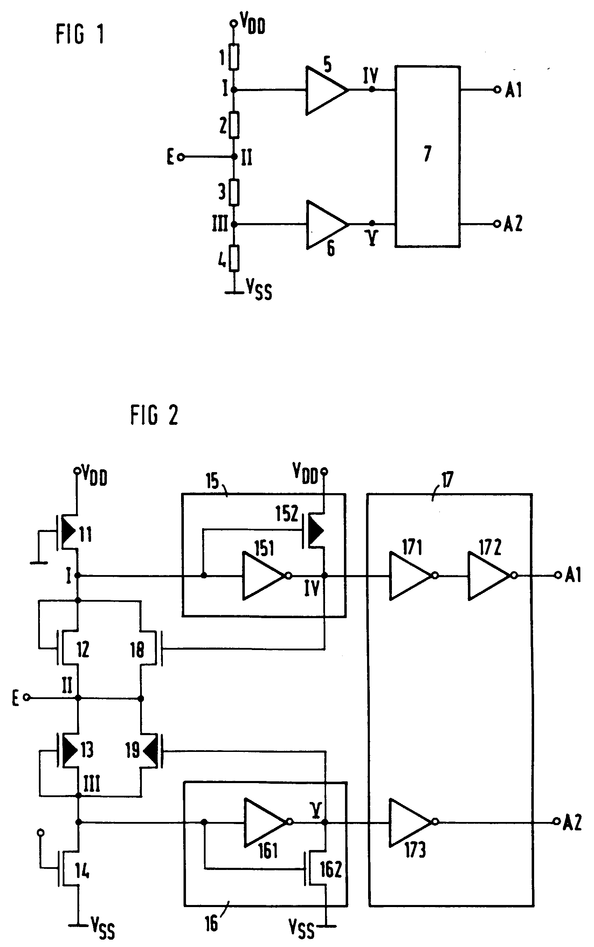

In Figur 1 ist ein steuerbarer erster Widerstand 1 mit einem zweiten Widerstand 2, einem dritten Widerstand 3 und einem vierten Widerstand 4 zwischen einem Betriebsspannungspotential V_{DD} und einem Bezugspotential V_{SS} in Serie geschaltet. Dadurch entstehen zwischen den Widerständen 1, 2, 3, 4 ein erster Verbindungsknoten I, ein zweiter Verbindungsknoten II und ein dritter Verbindungsknoten III. Der zweite Verbindungsknoten II bildet den Eingang E der in Figur 1 dargestellten Halbleiterschaltungsanordnung. Dieser Eingang wird mit einem ternären Eingangssignal, d.h. also mit einem Eingangssignal, das drei Zustände annehmen kann, beaufschlagt. Die drei Zustände sind dabei durch das Bezugspotential V_{SS}, das Betriebsspannungspotential V_{DD} und ein Potential, das zwischen diesen beiden Potentialen liegt, gegeben.

Mit dem ersten Verbindungsknoten I ist der Eingang eines ersten Schwellwertentscheiders 5 und mit dem dritten Verbindungsknoten III der Eingang eines zweiten Schwellwertentscheiders 6 verbunden. Die Ausgänge der beiden Schwellwertentscheider 5, 6 sind mit einer Logikschaltung 7 verbunden, deren beide Ausgänge die Ausgänge A1, A2 der Halbleiterschaltungsanordnung bilden.

Die Werte der vier Widerstände 1 bis 4 und die Schaltschwellen der Schwellwertentscheider 5, 6 sind bei der erfindungsgemäßen Halbleiterschaltungsanordnung so gewählt, daß bei einem Eingangssignal mit einem Zustand, der dem Bezugspotential V_{SS} entspricht, keiner der beiden Schwellwertentscheider 5, 6 durchschaltet und bei einem Eingangssignal mit einem Zustand, das dem Betriebsspannungspotential V_{DD} entspricht, beide Schwellwertentscheider 5, 6 durchschalten.

Durch entsprechende, dem handwerklichen Können des Fachmanns zuzuordnende Gestaltung der Logikschaltung 7 lassen sich an den Ausgängen A1, A2 die jeweils gewünschten binären Ausgangssignal bereitstellen.

Figur 2 zeigt eine erste, detaillierte Ausführungsform der erfindungsgemäßen integrierten Halbleiterschaltungsanordnung, bei der die vier Widerstände 1 bis 4 durch MOS-Transistoren 11, 12, 13, 14 gebildet sind. So ist dort ein erster p-Kanal-MOS-Transistor 11, dessen Gate-Anschluß auf Bezugspotential liegt mit einem ersten als Diode geschalteten n-Kanal-MOS-Transistor 12, mit einem zweiten, als Diode geschalteten p-Kanal-MOS-Transistor 13 und mit einem zweiten n-Kanal-MOS-Transistor 14, dessen Gate-Anschluß auf Betriebsspannungspotential V_{DD} liegt, in Serie zwischen dem Betriebsspannungspotential V_{DD} und dem Bezugspotential V_{SS} geschaltet.

Zwischen den vier MOS-Transistoren 11 bis 14 sind wiederum drei Verbindungsknoten I, II, III ausgebildet, wobei der zweite Verbindungsknoten II wieder den Eingang E der Halbleiterschaltungsanordnung bildet. Der erste Schwellwertentscheider 15, dessen Eingang mit dem ersten Verbindungsknoten I verbunden ist, ist durch einen symmetrischen CMOS-Inverter 151 gebildet, dem ein p-Kanal-MOS-Transistor 152 parallel geschaltet ist, so daß sich die Schaltschwelle des Schwellwertentscheiders 15 zu höheren Werten verschiebt.

Der zweite Schwellwertentscheider 16, dessen Eingang mit dem dritten Verbindungsknoten III verbunden ist, ist ebenfalls mit einem symmetrischen CMOS-Inverter 161 gebildet, dem allerdings ein n-Kanal-MOS-Transistor 162 parallel geschaltet ist, so daß sich dessen Schaltschwelle zu niederen Werten verschiebt. Auf diese Weise wird erzielt, daß die Zustände des Eingangssignals größere Toleranzbereiche aufweisen dürfen.

Zwischen dem ersten Verbindungsknoten I und dem zweiten Verbindungsknoten II ist ein dritter n-Kanal-MOS-Transistor 18 angeordnet, dessen Gate-Anschluß mit dem Ausgang IV des ersten Schwellvertentscheiders 15 verbunden ist, während zwischen dem zweiten Verbindungsknoten II und dem dritten Verbindungsknoten III ein dritter p-Kanal-MOS-Transistor 19 angeordnet ist, dessen Gate-Anschluß mit dem Ausgang V des zweiten Schwellwertentscheiders 16 verbunden ist.

Der Ausgang des ersten Schwellwertentscheiders 15 ist über eine Kettenschaltung von zwei Invertern 171, 172 mit dem Ausgang A1 der Halbleiterschaltungsanordnung verbunden. Der Ausgang des zweiten Schwellwertentscheiders 16 ist über einen Inverter 173 mit dem zweiten Ausgang A2 der Halbleiterschaltungsanordnung verbunden. Die drei Inverter 171, 172, 173 bilden die Logikschaltung 17.

Die vier in Serie geschalteten MOS-Transistoren 11 bis 14 sind so dimensioniert, daß sich bei schwebendem Eingang E der Halbleiterschaltungsanordnung am Verbindungsknoten II ein Potential von etwa 0.5 (V_{DD} - V_{SS}) ausbildet. Am Verbindungsknoten I bildet sich ein Potential von etwa 0.95 (V_{DD} - V_{SS}) und am Verbindungsknoten III ein Potential von etwa 0.05 (V_{DD} - V_{SS}) aus. Dieser Eingangszustand ist der Ruhebetriebszustand. Dabei hat der zweite Schwellwertentscheider 16 nicht durchgeschaltet, so daß sich an seinem Ausgang V ein logischer High-Pegel ergibt und sich entsprechend am zweiten Ausgang A2 der Halbleiterschaltungsanordnung ein logischer Low-Pegel ergibt. Der erste Schwellwertentscheider 15 hat durchgeschaltet, so daß sich an seinem Ausgang IV ein logischer Low-Pegel einstellt und sich am ersten Ausgang A1 der Halbleiterschaltungsanordnung ebenfalls ein logischer Low-Pegel einstellt.

Wird der Eingang E der Halbleiterschaltungsanordnung auf Bezugspotential gelegt, so sinkt das Potential am dritten Verbindungsknoten III ebenfalls auf Bezugspotential ab, so daß der zweite Schwellwertentscheider 16 weiterhin nicht durchschaltet und am zweiten Ausgang A2 der Halbleiterschaltungsanordnung der Low-Pegel aufrecht erhalten bleibt. Das Potential am ersten Verbindungsknoten I sinkt ebenfalls ab, so daß der erste Schwellwertentscheider 15 schaltet, wodurch an seinem Ausgang IV ein High-Pegel auftritt. Mit diesem Pegel wird der Gate-Anschluß des dritten n-Kanal-MOS-Transistors 18 beaufschlagt, so daß dieser niederohmig wird und den Verbindungsknoten I auf das Potential des Verbindungsknoten II, also auf Bezugspotential herunterzieht. Dadurch wird der Schaltzustand des ersten Schwellwertentscheiders 15 stabilisiert. Der erste Ausgang Al der Halbleiterschaltungsanordnung weist nun einen High-Pegel auf. Wird hingegen der Eingang E auf Betriebsspannungspotential V_{DD} gelegt, so liegt der erste Verbindungsknoten I ebenfalls auf diesem Potential, was bedeutet, daß der Ausgang IV des ersten Schwellwertentscheiders 15 und auch der erste Ausgang Al der Halbleiterschaltungsanordnung auf Low-Potential liegt. Das Potential des dritten Verbindungsknotens III wird etwas angehoben, so daß der zweite Schwellwertentscheider 16 schaltet und dessen Ausgang V einen Low-Pegel aufweist. Dadurch wird der dritte p-Kanal-MOS-Transistor 19 niederohmig, wodurch der dritte Verbindungsknoten III auf Betriebsspannungspotential V_{DD} angehoben wird und den Zustand des zweiten Schwellwertentscheiders 16 stabilisiert. Der zweite Ausgang A2 der Halbleiterschaltungsanordnung weist in diesem Fall einen High-Pegel auf. Es ergibt sich also folgende Wahrheitstabelle:

| E | A1 | A2 |
|---|---|---|
| / | 0 | 0 |
| V_{DD} | 0 | 1 |
| V_{SS} | 1 | 0 |

Der Vorteil der Halbleiterschaltungsanordnung gemäß Figur 2 liegt darin, daß im Ruhebetriebszustand, also wenn die Schaltungsanordnung, die ja Bestandteil einer größeren Halbleiterschaltung ist, nicht benötigt wird, der Eingang E in einem schwebenden Zustand belassen werden kann, also nicht beschaltet oder mit einem Signal beaufschlagt werden muß. Sie weist allerdings den Nachteil auf, daß in diesem Ruhebetriebszustand ein Ruhestrom durch die vier in Serie geschalteten MOS-Transistoren fließt, der zu einer Verlustleistung führt.

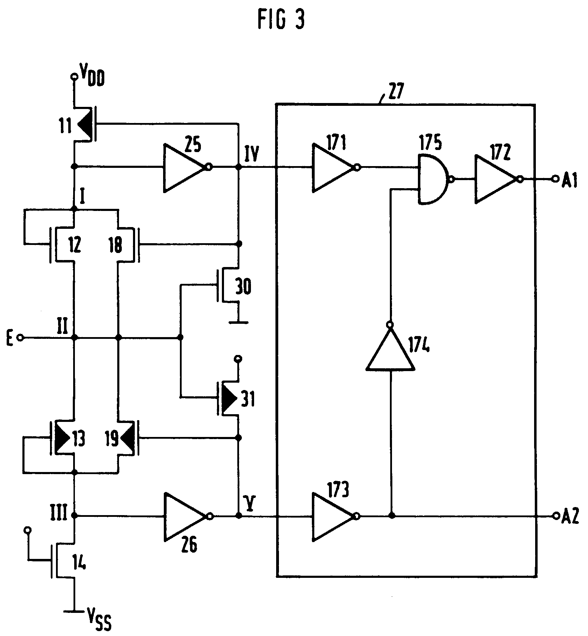

Diesen Nachteil vermeidet die Halbleiterschaltungsanordnung gemäß Figur 3, in der gleiche Schaltungsbestandteile, die die gleiche Funktion erfüllen wie bei der Schaltungsanordnung gemäß Figur 2 mit denselben Bezugszeichen versehen sind.

Der wesentliche Unterschied besteht darin, daß der Gate-Anschluß des ersten p-Kanal-MOS-Transistors 11 nicht auf Bezugspotential liegt, sondern mit dem Ausgang IV des ersten Schwellwertentscheiders 25 verbunden ist. Wenn nun der Eingang E auf Bezugspotential gelegt wird, so schaltet der erste Schwellwertentscheider 25 seinen Ausgang IV auf einen High-Pegel, wodurch der erste p-Kanal-MOS-Transistor 11 hochohmig geschaltet wird und somit kein Strom mehr durch die vier in Serie geschalteten MOS-Transistoren 11 bis 14 fließen kann. Dieser Zustand ist dann der Ruhebetriebszustand.

Ebenso könnte natürlich auch der Gate-Anschluß des zweiten n-Kanal-MOS-Transistors 14 mit dem Ausgang V des zweiten Schwellwertentscheiders 26 verbunden sein, wodurch dann allerdings der Eingang E auf Betriebsspannungspotential gelegt werden müßte, um diesen zweiten n-Kanal-MOS-Transistor 14 zu sperren und somit einen Ruhestrom zu vermeiden.

Um dieselbe Konfiguration der Pegel der beiden Ausgänge A1, A2 der Halbleiterschaltungsanordnung bezüglich des Ruhebetriebszustands und der beiden aktiven Betriebszustände wie bei der Halbleiterschaltungsanordnung gemäß Figur 2 zu erhalten, ist eine andere Logikschaltung 27 nötig. Neben den bereits in der Logikschaltung 17 gemäß Figur 2 enthaltenen Invertern 171, 172, 173 ist zwischen die beiden Inverter 171, 172 ein NAND-Gatter 175 geschaltet, dessen zweiter Eingang über einen weiteren Inverter 174 mit dem zweiten Ausgang A2 der Halbleiterschaltungsanordnung verbunden ist. Dadurch wird erreicht, daß im Ruhebetriebszustand, also wenn der Eingang E auf Bezugspotential liegt, die beiden Eingänge A1, A2 einen Low-Pegel aufweisen. Wenn der Eingang E auf Betriebsspannungspotential liegt, weist der erste Ausgang A1 einen High-Pegel und der zweite Ausgang A2 einen Low-Pegel auf, und wenn der Eingang E ein Potential von 0.5 (V_{DD} - V_{SS}) aufweist, weist der erste Ausgang A1 einen Low-Pegel und der zweite Ausgang A2 einen High-Pegel auf.

Damit im Falle, wenn der Eingang E ein Potential von 0.5 (V_{DD} - V_{SS}) aufweist, der erste Schwellwertentscheider 25 nicht über dem dritten n-Kanal-MOS-Transistor 18 bzw. der zweite Schwellwertentscheider 26 über dem dritten p-Kanal-MOS-Transistor 19 verriegelt wird, sind zwischen den Ausgang IV des ersten Schwellwertentscheiders 25 und Bezugspotential V_{SS} ein vierter n-Kanal-MOS-Transistor 30, dessen Gate-Anschluß mit dem zweiten Verbindungsknoten II verbunden ist und zwischen den Ausgang V des zweiten Schwellwertentscheiders 26 und dem Betriebsspannungspotential V_{DD} ein vierter p-Kanal-MOS-Transistor 31, dessen Gate-Anschluß ebenfalls mit dem zweiten Verbindungsknoten 2 verbunden ist, angeordnet.

Die beiden Schwellwertentscheider 25, 26 sind unsymmetrische CMOS-Inverter, die beispielsweise durch Parallelschaltung eines symmetrischen CMOS-Inverters mit einem n-Kanal-MOS-Transistor oder mit einem p-Kanal-MOS-Transistor gebildet werden können.

## Patentansprüche

1. Integrierte Halbleiterschaltungsanordnung mit einem Eingang und zwei Ausgängen zum Wandeln eines ternären Eingangssignals in zwei binäre Ausgangssignale,
mit einem ersten (1; 11), einem zweiten (2; 12), einem dritten (3; 13) und einem vierten (4; 14) Widerstand, die zwischen einem Betriebsspannungspotential (V_{DD}) und einem Bezugspotential (V_{SS}) in Serie geschaltet sind, so daß zwischen den vier Widerständen (1, 2, 3, 4; 11, 12, 13, 14) ein erster (I) , ein zweiter (II) und ein dritter (III) Verbindungsknoten ausgebildet ist, wobei der zweite Verbindungsknoten (II) den Eingang (E) der Halbleiterschaltungsanordnung bildet und wobei der zweite und der dritte Widerstand (2, 3; 12; 13) mit Dioden gebildet sind,
mit einem ersten Schwellwertentscheider (5; 15; 25), dessen Eingang mit dem ersten Verbindungsknoten (I) verbunden ist, mit einem zweiten Schwellwertentscheider (6; 16; 26), dessen Eingang mit dem dritten Verbindungsknoten (III) verbunden ist,
**dadurch gekennzeichnet**,
daß der erste Widerstand (1) durch einen ersten p-Kanal-MOS-Transistor (11) gebildet ist, dessen Gate-Anschluß mit dem Ausgang (IV) des ersten Schwellwertentscheiders (25) verbunden ist,
daß der zweite Widerstand (2) durch einen als Diode betriebenen ersten n-Kanal-MOS-Transistor (12) gebildet ist, daß der dritte Widerstand (3) durch einen als Diode betriebenen zweiten p-Kanal-MOS-Transistor (13) gebildet ist und
daß der vierte Widerstand (4) durch einen zweiten n-Kanal-MOS-Transistor (14) gebildet ist, dessen Gate-Anschluß mit dem Betriebsspannungspotential verbunden ist und
daß eine Logikschaltung (7; 17; 27) vorgesehen ist, die mit den Ausgängen (IV, V) der Schwellwertentscheider (59 6; 15, 16; 25, 26) verbunden ist und deren Ausgänge die Ausgänge (A1, A2) der Halbleiterschaltungsanordnung bilden.

2. Integrierte Halbleiterschaltungsanordnung mit einem Eingang und zwei Ausgängen zum Wandeln eines ternären Eingangssignals in zwei binäre Ausgangssignale,
mit einem ersten (1; 11), einem zweiten (2; 12), einem dritten (3; 13) und einem vierten (4; 14) Widerstand, die zwischen einem Betriebsspannungspotential (V_{DD}) und einem Bezugspotential (V_{SS}) in Serie geschaltet sind, so daß zwischen den vier Widerständen (1, 2, 3, 4; 11, 12, 13, 14) ein erster (I) , ein zweiter (II) und ein dritter (III) Verbindungsknoten ausgebildet ist, wobei der zweite Verbindungsknoten (II) den Eingang (E) der Halbleiterschaltungsanordnung bildet und wobei der zweite und der dritte Widerstand (2, 3; 12; 13) mit Dioden gebildet sind,
mit einem ersten Schwellwertentscheider (5; 15; 25), dessen Eingang mit dem ersten Verbindungsknoten (I) verbunden ist, mit einem zweiten Schwellwertentscheider (6; 16; 26), dessen Eingang mit dem dritten Verbindungsknoten (III) verbunden ist,
**dadurch gekennzeichnet**,
daß der erste Widerstand (1) durch einen ersten p-Kanal-MOS-Transistor (11) gebildet ist, dessen Gate-Anschluß mit dem Bezugspotential verbunden ist,
daß der zweite Widerstand (2) durch einen als Diode betriebenen ersten n-Kanal-MOS-Transistor (12) gebildet ist, daß der dritte Widerstand (3) durch einen als Diode betriebenen zweiten p-Kanal-MOS-Transistor (13) gebildet ist und
daß der vierte Widerstand (4) durch einen zweiten n-Kanal-MOS-Transistor (14) gebildet ist, dessen Gate-Anschluß mit dem Ausgang (V) des zweiten Schwellwertentscheiders (16; 26) verbunden ist und
daß eine Logikschaltung (7; 17; 27) vorgesehen ist, die mit den Ausgängen (IV, V) der Schwellwertentscheider (59 6; 15, 16; 25, 26) verbunden ist und deren Ausgänge die Ausgänge (A1, A2) der Halbleiterschaltungsanordnung bilden.

3. Integrierte Halbleiterschaltungsanordnung nach Anspruch 1 oder 2, **dadurch gekennzeichnet**,
daß der erste Schwellwertentscheider (15; 25) mit einem ersten CMOS-Inverter und der zweite Schwellwertentscheider (16; 26) mit einem zweiten CMOS-Inverter gebildet ist.

4. Integrierte Halbleiterschaltungsanordnung nach einem der Ansprüche 1 bis 3, **dadurch gekennzeichnet**,
daß parallel zum zweiten Widerstand (12) ein dritter n-Kanal-MOS-Transistor (18), dessen Gate-Anschluß mit dem Ausgang des ersten Schwellwertentscheiders (15; 25) verbunden ist, angeordnet ist und daß parallel zum dritten Widerstand (13) ein dritter p-Kanal-MOS-Transistor (19), dessen Gate-Anschluß mit dem Ausgang des zweiten Schwellwertentscheiders (16; 26) verbunden ist, angeordnet ist.

5. Integrierte Halbleiterschaltungsanordnung nach Anspruch 4, **dadurch gekennzeichnet**,
daß zwischen dem Ausgang (IV) des ersten Schwellwertentscheiders (25) und dem Bezugspotential ein vierter n-Kanal-MOS-Transistor (30), dessen Gate-Anschluß mit dem zweiten Verbindungsknoten (II) verbunden ist und daß zwischen dem Betriebsspannungspotential (V_{DD}) und dem Ausgang (V) des zweiten Schwellwertentscheiders (26) ein vierter p-Kanal-MOS-Transistor (31), dessen Gate-Anschluß mit dem zweiten Verbindungsknoten (II) verbunden ist, angeordnet ist.

## Claims

1. Integrated semiconductor circuit arrangement having one input and two outputs for converting a ternary input signal into two binary output signals,
having a first resistor (1; 11), a second resistor (2; 12), a third resistor (3; 13) and a fourth resistor (4; 14), which resistors are connected in series between an operating voltage potential (V_{DD}) and a reference-earth potential (V_{SS}), with the result that a first connecting node (I), a second connecting node (II) and a third connecting node (III) are formed between the four resistors (1, 2, 3, 4; 11, 12, 13, 14), the second connecting node (II) forming the input (E) of the semiconductor circuit arrangement, and the second and third resistors (2, 3; 12; 13) being formed by diodes,
having a first threshold value decision circuit (5; 15; 25), whose input is connected to the first connecting node (I),
having a second threshold value decision circuit (6; 16; 26), whose input is connected to the third connecting node (III),
characterized
in that the first resistor (1) is formed by a first p-channel MOS transistor (11) whose gate terminal is connected to the output (IV) of the first threshold value decision circuit (25),
in that the second resistor (2) is formed by a first n-channel MOS transistor (12), which is operated as a diode,
in that the third resistor (3) is formed by a second p-channel MOS transistor (13), which is operated as a diode, and
in that the fourth resistor (4) is formed by a second n-channel MOS transistor (14), whose gate terminal is connected to the operating voltage potential, and
in that a logic circuit (7; 17; 27) is provided, which is connected to the outputs (IV, V) of the threshold value decision circuits (5, 6; 15, 16; 25, 26) and whose outputs form the outputs (A1, A2) of the semiconductor circuit arrangement.

2. Integrated semiconductor circuit arrangement having one input and two outputs for converting a ternary input signal into two binary output signals,
having a first resistor (1; 11), a second resistor (2; 12), a third resistor (3; 13) and a fourth resistor (4; 14), which resistors are connected in series between an operating voltage potential (V_{DD}) and a reference-earth potential (V_{SS}), with the result that a first connecting node (I), a second connecting node (II) and a third connecting node (III) are formed between the four resistors (1, 2, 3, 4; 11, 12, 13, 14), the second connecting node (II) forming the input (E) of the semiconductor circuit arrangement, and the second and third resistors (2, 3; 12; 13) being formed by diodes,
having a first threshold value decision circuit (5; 15; 25), whose input is connected to the first connecting node (I),
having a second threshold value decision circuit (6; 16; 26), whose input is connected to the third connecting node (III),
characterized
in that the first resistor (1) is formed by a first p-channel MOS transistor (11), whose gate terminal is connected to the reference-earth potential,
in that the second resistor (2) is formed by a first n-channel MOS transistor (12), which is operated as a diode,
in that the third transistor (3) is formed by a second p-channel MOS transistor (13), which is operated as a diode, and
in that the fourth resistor (4) is formed by a second n-channel MOS transistor (14), whose gate terminal is connected to the output (V) of the second threshold value decision circuit (16; 26), and
in that a logic circuit (7; 17; 27) is provided, which is connected to the outputs (IV, V) of the threshold value decision circuits (5, 6; 15, 16; 25, 26) and whose outputs form the outputs (A1, A2) of the semiconductor circuit arrangement.

3. Integrated semiconductor circuit arrangement according to Claim 1 or 2, characterized
in that the first threshold value decision circuit (15; 25) is formed by a first CMOS invertor, and the second threshold value decision circuit (16; 26) is formed by a second CMOS invertor.

4. Integrated semiconductor circuit arrangement according to one of Claims 1 to 3 characterized
in that a third n-channel MOS transistor (18), whose gate terminal is connected to the output of the first threshold value decision circuit (15; 25), is arranged in parallel with the second resistor (12), and in that a third p-channel MOS transistor (19), whose gate terminal is connected to the output of the second threshold value decision circuit (16; 26), is arranged in parallel with the third resistor (13).

5. Integrated semiconductor circuit arrangement according to Claim 4, characterized
in that a fourth n-channel MOS transistor (30), whose gate terminal is connected to the second connecting node (II), is arranged between the output (IV) of the first threshold value decision circuit (25) and the reference-earth potential, and in that a fourth p-channel MOS transistor (31), whose gate terminal is connected to the second connecting node (II), is arranged between the operating voltage potential (V_{DD}) and the output (V) of the second threshold value decision circuit (26).

## Revendications

1. Circuit intégré à semi-conducteurs comportant une entrée et deux sorties pour la conversion d'un signal d'entrée ternaire en deux signaux de sortie binaires,
une première résistance (1 ; 11), une seconde résistance (2 ; 12), une troisième résistance (3 ; 13) et une quatrième résistance (4 ; 14) qui sont branchées en série entre un potentiel de tension de fonctionnement (V_{DD}) et un potentiel de référence (V_{SS}), de manière à former entre les quatre résistances (1, 2, 3, 4 ; 11, 12, 13, 14) un premier point de jonction (I), un second point de jonction (II) et un troisième point de jonction (III), le second point de jonction (II) formant l'entrée (E) du circuit intégré à semi-conducteurs et la seconde et la troisième résistance (2,3; 12,13) étant formées de diodes,
un premier discriminateur à valeur de seuil (5 ; 15; 25) dont l'entrée est reliée au premier point de jonction (I), et
un second discriminateur à valeur de seuil (6 ; 16 ; 26) dont l'entrée est reliée au troisième point de jonction (III),
caractérisé par le fait
que la première résistance (1) est formée par un premier transistor MOS à canal p (11) dont la borne de grille est reliée à la sortie (IV) du premier discriminateur à valeur de seuil (25),
que la seconde résistance (2) est formée par un premier transistor MOS à canal n (12) fonctionnant comme une diode,
que la troisième résistance (3) est formée par un second transistor MOS à canal p (13) fonctionnant comme une diode, et
que la quatrième résistance (4) est formée par un second transistor MOS à canal n (14) dont la borne de grille est reliée au potentiel de tension de fonctionnement, et
qu'il est prévu un circuit logique (7 ; 17 ; 27) qui est relié aux sorties (IV, V) des discriminateurs à valeur de seuil (5, 6 ; 15, 16 ; 25, 26) et dont les sorties forment les sorties (A1, A2) du circuit intégré à semi-conducteurs.

2. Circuit intégré à semi-conducteurs comportant une entrée et deux sorties pour la conversion d'un signal d'entrée ternaire en deux signaux de sortie binaires,
une première résistance (1 ; 11), une seconde résistance (2 ; 12), une troisième résistance (3 13) et une quatrième résistance (4 ; 14) qui sont branchées en série entre un potentiel de tension de fonctionnement (V_{DD}) et un potentiel de référence (V_{SS}), de manière à former entre les quatre résistances (1, 2, 3, 4 ; 11, 12, 13, 14) un premier point de jonction (I), un second point de jonction (II) et un troisième point de jonction (III), le second point de jonction (II) formant l'entrée (E) du circuit intégré à semi-conducteurs et la seconde et la troisième résistances (2,3;12,13) étant formées de diodes,
un premier discriminateur à valeur de seuil (5 ; 15; 25) dont l'entrée est reliée au premier point de jonction (I), et
un second discriminateur à valeur de seuil (6 16 26) dont l'entrée est reliée au troisième point de jonction (III),
caractérisé par le fait
que la première résistance (1) est formée d'un premier transistor MOS à canal p (11) dont la borne de grille est reliée au potentiel de référence,
que la seconde résistance (2) est formée par un premier transistor MOS à canal n (12) fonctionnant comme une diode,
que la troisième résistance (3) est formée par un second transistor MOS à canal p (13) fonctionnant comme une diode,
que la quatrième résistance (4) est formée par un second transistor MOS à canal n (14) dont la borne de grille est reliée à la sortie (V) du second discriminateur à valeur de seuil (16 ; 26),
et qu'il est prévu un circuit logique (7 ; 17 ; 27) qui est relié aux sorties (IV, V) des discriminateurs à valeur de seuil (5, 6 ; 15, 16 ; 25, 26) et dont les sorties forment les sorties (A1, A2) du circuit intégré à semi-conducteurs.

3. Circuit intégré à semi-conducteurs selon la revendication 1 ou 2, caractérisé par le fait que le premier discriminateur à valeur de seuil (15 ; 25) est formé d'un premier inverseur CMOS et le second discriminateur à valeur de seuil (16 ; 26) est formé d'un second inverseur CMOS.

4. Circuit intégré à semi-conducteurs selon l'une des revendications 1 à 3, caractérisé par le fait qu'un troisième transistor MOS à canal n (18) dont la borne de grille est reliée à la sortie du premier discriminateur à valeur de seuil (15 ; 25) est agencé en parallèle avec la seconde résistance (12), et un troisième transistor MOS à canal p (19), dont la borne de grille est reliée à la sortie du second discriminateur à valeur de seuil (16 26), est agencé en parallèle avec la troisième résistance (13).

5. Circuit intégré à semi-conducteurs selon la revendication 4, caractérisé par le fait qu'un quatrième transistor MOS à canal n (30), dont la borne de grille est reliée au second point de jonction (II), est agencé entre la sortie (IV) du premier discriminateur à valeur de seuil (25) et le potentiel de référence, et qu'un quatrième transistor MOS à canal p (31), dont la borne de grille est reliée au second point de jonction (II), est agencé entre le potentiel de tension de fonctionnement (V_{DD}) et la sortie (V) du second discriminateur à valeur de seuil (26).
